# EUROPEAN PATENT SPECIFICATION

(11) **EP 2 229 694 B1**
(45) Date of publication and mention of the grant of the patent: **25.01.2017**
(21) Application number: 08855955.4
(22) Date of filing: 04.12.2008
(51) Int. Cl.: H01L 23/485, H01L 21/60, H01L 23/528, H01L 23/50, H01L 23/525, H01L 21/56

(54) **SEMICONDUCTOR CHIP UNDER-BUMP METALLIZATION STRUCTURE AND MANUFACTURING METHOD THEREOF**
HALBLEITERCHIP MIT UNDER-BUMP-METALLISIERUNGSSTRUKTUR UND VERFAHREN ZU DESSEN HERSTELLUNG
STRUCTURE DE MÉTALLISATION DE RÉCEPTION DE BILLES SUR PUCE SEMICONDUCTRICE ET PROCÉDÉ POUR SA FABRICATION

(30) Priority: 04.12.2007 US 949951
(43) Date of publication of application: 22.09.2010
(60) Divisional application: 14188046.8
(73) Proprietor: Conversant Intellectual Property Management, Inc., Ottawa, ON K2K 3G4 (CA)
(72) Inventor: MCLELLAN, Neil, Toronto Ontario M2K 3B8 (CA); LI, Yue, Markham Ontario L3P 7K5 (CA); TOPACIO, Roden, Markham Ontario L3R 4S8 (CA); CHEUNG, Terence, Toronto Ontario M2N 7E3 (CA)
(74) Representative: Kenrick, Mark Lloyd
(86) International application number: PCT/IB2008/003343
(87) International publication number: WO 2009/071982

(56) References cited:
- WO-A-2006/129832
- JP-A- 2000 031 188
- JP-A- 2006 203 261
- US-A- 5 907 785
- US-A1- 2005 280 034
- US-A1- 2006 033 197
- US-A1- 2007 170 587

## Description

### BACKGROUND OF THE INVENTION

### 1. Field of the Invention

This invention relates generally to semiconductor processing, and more particularly to semiconductor die conductor structures and to methods of making the same. Some documents in this technical field are WO 2006/129832, JP 2000 031188 and US 5 907 785.

### 2. Description of the Related Art

Conventional integrated circuits are frequently implemented on a semiconductor substrate or die that consists of a small rectangular piece of semiconductor material, typically silicon, fashioned with two opposing principal sides. The active circuitry for the die is concentrated near one of the two principal sides. The side housing the active circuitry is usually termed the "active circuitry side," while the side opposite the active circuitry side is often referred to as the "bulk silicon side." Depending on the thermal output of the die, it may be desirable to mount a heat transfer device, such as a heat sink, on the bulk silicon side of the die. This mounting may be directly on the bulk silicon side or on a lid that is positioned over the die.

A conventional die is usually mounted on some form of substrate, such as a package substrate or a printed circuit board. Electrical conductivity between the die and the underlying substrate or board is established through a variety of conventional mechanisms. In a so-called flip-chip configuration, the active circuitry side of the die is provided with a plurality of conductor balls or bumps that are designed to establish a metallurgical bond with a corresponding plurality of conductor pads positioned on the substrate or circuit board. The die is flipped over and seated on the underlying substrate with the active circuitry side facing downwards. A subsequent thermal process is performed to establish the requisite metallurgical bond between the bumps and the pads. One of the principal advantages of a flip-chip mounting strategy is the relatively short electrical pathways between the integrated circuit and the substrate. These relatively low inductance pathways yield a high speed performance for the electronic device.

The manner in which the solder balls are electrically connected to the bond pads of the semiconductor die may have a significant impact on the reliability of semiconductor die and the host electronic device to which it is mounted. In one conventional technique, a dielectric passivation layer is fabricated on the active circuitry side of the semiconductor die and lithographically patterned with a plurality of openings corresponding to the locations of the bond pads. Next, a polyimide layer is fabricated over the passivation layer and lithographically patterned with a plurality of openings that are generally concentrically positioned relative to the openings in the passivation layer. A so-called under bump metallization layer is next deposited over the polyimide layer so that metal extends down to and bonds with the underlying bond pads. Thus, the polyimide layer is positioned between the under bump metal layer and the passivation layer. The significance of this arrangement will be explained in further detail below. After the under bump metallization layer is formed, a film or stencil is patterned on the under bump metal layer with a plurality of openings that are positioned over the general locations of the bond pads and a solder material is deposited by a plating or stencil paste process. The stencil is removed and a thermal process is performed to reflow the solder structures. The solder structures solidify into ball-like structures.

Lead-based solders have been widely used in semiconductor device fabrication for decades. More recently, however, chip manufacturers have begun turning to lead-free solders. Lead-free solder materials tend to have relatively lower ductility than lead-based solders. This increased stiffness can lead to significant stresses in the solder balls, particularly where operating temperatures are high or where there is a significant mismatch between the coefficients of thermal expansion between the semiconductor die and the substrate upon which it is mounted. The difficulty with the conventional technique stems from the relative positions of the polyimide layer, the under bump metallization layer and the solder balls. Because the polyimide layer is essentially separated from the solder balls by the under bump metallization layer, the stress reducing abilities of the polyimide layer are not available to the solder balls. Accordingly, high mechanical stresses may be inflicted on the solder balls, particularly at the edges of the solder balls near the interfaces with the under bump metallization layer. The stresses can lead to cracks in the solders balls. If the stresses are acute enough, mechanical failure of the solder balls can occur and produce electrical device failure.

The present invention is directed to overcoming or reducing the effects of one or more of the foregoing disadvantages.

### SUMMARY OF THE INVENTION

One aspect of the present invention provides a method of semiconductor processing, comprising: forming an underbump metallization structure on a semiconductor chip, the underbump metallization structure having a first site electrically connected to a first redistribution layer structure and a second site electrically connected to a second redistribution layer structure, said redistribution layer structures providing electrical routing between circuit devices in the semiconductor chip and the underbump metallization structure; wherein the forming of the underbump metallization structure comprises forming a cluster having a hub adapted for mounting a solder structure thereon and at least the first and second sites are connected to the hub; and forming a solder structure on the hub.

Another aspect of the present invention provides a semiconductor chip, comprising: at least two redistribution layer structures; an underbump metallization structure on the semiconductor chip, the underbump metallization structure having a first site electrically connected to a first of the at least two redistribution layer structures and a second site electrically connected to a second of the at least two redistribution layer structures, said redistribution layer structures providing electrical routing between circuit devices in the semiconductor chip and the underbump metallization structure; wherein the underbump metallization structure comprises a cluster having a hub and the first and second sites coupled to the hub and a solder structure on the hub.

An apparatus is described that includes a semiconductor die that has a conductor pad with a surface. A conductor structure is electrically coupled to the conductor pad. A polymeric layer is positioned on the surface of the conductor structure and has an opening to a portion of the surface of the conductor structure. A solder structure is coupled to the portion of the surface of the conductor structure.

An apparatus is described that includes a semiconductor die coupled to a first substrate. The semiconductor die includes a conductor pad that has a surface. A conductor structure is electrically coupled to the conductor pad. A polymeric layer is positioned on the surface of the conductor structure and has an opening to a portion of the surface of the conductor structure. A solder structure is coupled to the portion of the surface of the conductor structure.

A method of manufacturing is described that includes forming a conductor structure on a semiconductor chip. The conductor structure has a first site electrically connected to a first redistribution layer structure and a second site electrically connected to a second redistribution layer structure. A solder structure is formed on the conductor structure.

A method of manufacturing is described that includes forming a first conductor structure on a semiconductor chip. The first conductor structure has a first site electrically connected to a first redistribution layer structure and a second site electrically connected to a second redistribution layer structure. A second conductor structure is formed on the semiconductor chip. The second conductor structure has a third site electrically connected to a third redistribution layer structure and a fourth site electrically connected to a fourth redistribution layer structure. A first solder structure is formed on the first conductor structure and a second solder structure is formed on the second conductor structure.

A method of manufacturing is described that includes forming a conductor structure on a semiconductor chip. The conductor structure has a plurality of sites electrically connected to a redistribution layer. At least one solder structure is formed on the conductor structure proximate one of the plurality of sites.

An apparatus is described that includes a semiconductor chip that has at least two redistribution layer structures. A conductor structure is on the semiconductor chip. The conductor structure has a first site electrically connected to a first of the at least two redistribution layer structures and a second site electrically connected to a second of the at least two redistribution layer structures. A solder structure is on the conductor structure.

### BRIEF DESCRIPTION OF THE DRAWINGS

The foregoing and other advantages of the invention will become apparent upon reading the following detailed description and upon reference to the drawings in which:
FIG. 1 is a sectional view of a conventional semiconductor die with a bond pad and passivation layer;
FIG. 2 is a sectional view of a conventional semiconductor die following polyimide and metal layer deposition;
FIG. 3 is a sectional view of a conventional semiconductor die following mask formation;
FIG. 4 is a sectional view of a conventional semiconductor die following solder deposition;
FIG. 5 is a sectional view of a conventional semiconductor die following solder reflow to establish a bump;
FIG. 6 is a sectional view of a conventional semiconductor die following flip-chip mounting;
FIG. 7 is a portion of the sectional view of FIG. 6 depicted at greater magnification;
FIG. 8 is a sectional view of an example of a semiconductor die following passivation layer formation;
FIG. 9 is a sectional view of the example of the semiconductor die depicting metal layer and insulating layer formation;
FIG. 10 is a sectional view of the example of the semiconductor die depicting formation of a mask thereon;
FIG. 11 is a sectional view of the example of the semiconductor die depicting formation of a conductor structure thereon;
FIG. 12 is a sectional view of the example of the semiconductor die depicting a reflow of the conductor structure;
FIG. 13 is a sectional view of the example of the semiconductor die depicting an exemplary mounting to a substrate;
FIG. 14 is a sectional view of an alternate example of a semiconductor die depicting passivation, metal layer and mask formation thereon;
FIG. 15 is a sectional view of the alternate example of the semiconductor die depicting removal of the mask and portions of the metal layer;
FIG. 16 is a sectional view of the alternate example of the semiconductor die depicting formation of an insulating layer thereon;
FIG. 17 is a sectional view of the alternate example of the semiconductor die depicting formation of a conductor structure thereon;
FIG. 18 is a sectional view of the alternate example of the semiconductor die depicting a reflow of the conductor structure;
FIG. 19 is a pictorial view of another alternate example of a semiconductor die provided with plural bump structures and a common metal layer;
FIG. 20 is an exploded pictorial view of an exemplary semiconductor die depicting exemplary mounting configurations;
FIG. 21 is a pictorial view of an exemplary conventional semiconductor chip positioned bottom side up so that a plurality of conductor balls are visible;
FIG. 22 is a magnified pictorial view of a small portion of the conventional semiconductor chip depicted in FIG. 21;
FIG. 23 is a pictorial view of an example of a semiconductor chip positioned bottom side up to reveal a plurality of solder structures;
FIG. 24 is a magnified pictorial view of a portion of the semiconductor chip depicted in FIG. 23;
FIG. 25 is a pictorial view of another portion of the semiconductor chip depicted in FIG. 23;
FIG. 26 is a plan view of another portion of the semiconductor chip depicted in FIG.
FIG. 27 is a plan view of another portion of the semiconductor chip depicted in FIG.
FIG. 28 is a plan view of a small portion of an exemplary embodiment of a semiconductor chip;
FIG. 29 is a sectional view of FIG. 28 taken section 28-28; and
FIG. 30 is a pictorial view of an exemplary semiconductor chip peeled up from a substrate to reveal various features.

### DETAILED DESCRIPTION OF SPECIFIC EMBODIMENTS

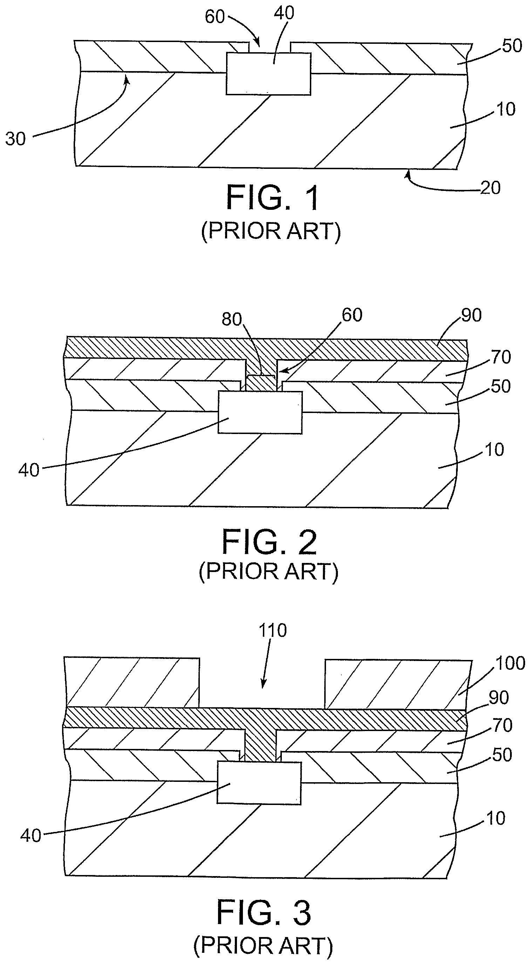

In the drawings described below, reference numerals are generally repeated where identical elements appear in more than one figure. Before discussing the exemplary embodiments disclosed herein, it will be instructive to review briefly the structure and manufacture of a conventional solder bump metallization design. Turning now to the drawings, and in particular to FIGS. 1-5, therein is shown an exemplary conventional fabrication process for forming a conductive solder bump on the lower surface of a semiconductor chip 10. For simplicity of illustration, FIGS. 1-5 focus on a relatively small portion of a semiconductor device 10. Turning initially to FIG. 1, the semiconductor device 10 includes two opposing sides 20 and 30. The side 20 is often referred to as a backside and the opposite side 30 is sometimes referred to as a front side. Active chip circuitry (not visible) is typically positioned in one or more layers proximate the front side 30. A bond pad 40 is provided proximate the side 30 and designed to provide an electrical pathway from the circuitry of the device 10 through a later-formed solder bump to establish electrical conductivity with circuitry external to the device 10. There may be scores of such bond pads 40 depending on the complexity of the device 10. A passivation layer 50 of silicon nitride is formed on the side 30 and patterned so that an opening 60 extends to the bond pad 40. The passivation layer 50 is designed to prevent the diffusion of metallic materials down into the semiconductor device 10.

Referring now to FIG. 2, a polyimide layer 70 is formed on the stack consisting of the passivation layer 50, the bond pad 40 and the semiconductor device 10. The polyimide layer 70 is formed with an opening 80 that is concentrically positioned with the opening 60 in the passivation layer 50. Polyimide is chosen for its ability to provide both advantageous structural flexibility and electrical insulation. Following the application of the polyimide layer 70, a metallization layer 90 is formed on the polyimide layer 70 and down through the opening 80 therein to establish ohmic contact with the bond pad 40. The metallization layer 90 is sometimes referred to as an under bump metallization layer or UBM layer. The UBM layer 90 is sometimes deposited as a sequential stack of different metallic materials, such as titanium copper and nickel.

As shown in FIG. 3, an insulating film 100 is formed on the stack consisting of the metallization layer 90, the polyimide layer 70, the passivation layer 50, the bond pad 40 and the device 10. An opening 110 is patterned in the film 100 that exposes a portion of the metallization layer 90. The film 100 is designed to serve as a mask, or a stencil if a stencil process is used, to enable the subsequent deposition of a conductor material in the opening 110 that will ultimately be fashioned into a solder bump. The opening 110 is typically formed by a lithographic patterning process.

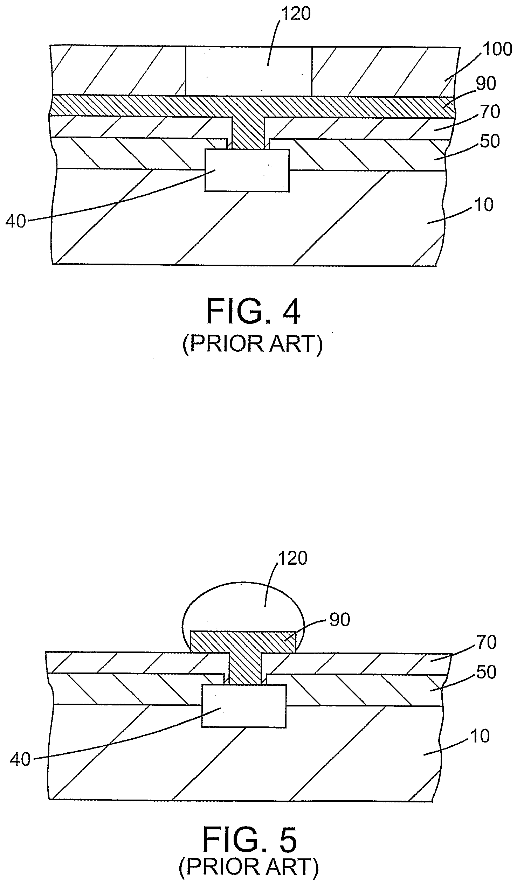

Referring now to FIG. 4, the semiconductor device 10 undergoes a plating process so that a conductor material 120 is deposited in the opening 110 of the film 100 and on the exposed portion of the metallization layer 90. The conductor material is typically a solder that establishes ohmic contact with the metallization layer 90. A conventional solder consists of a tin-lead mixture. A more recent innovation involves the use of a lead-free solder, such as a tin-copper solder. The polyimide layer 70 and the passivation layer inhibit diffusion of material from the conductor 120 and the metallization layer 90 into the device 10. The bond pad 40 is unaffected by the plating.

The film 100 depicted in FIG. 4 is removed and a thermal reflow process is performed on the semiconductor device 10 as depicted in FIG. 5 to reflow the conductor material 120 into a rounded bump. Following the solder reflow process, portions of the metallization layer 90 lateral to the solder bump 120 are etched away by wet etching. At this point, an ohmic pathway exists between the solder bump 120, the metallization layer 90 and the underlying bump pad 40. The passivation layer 50 and the polyimide layer 70 remain in place.

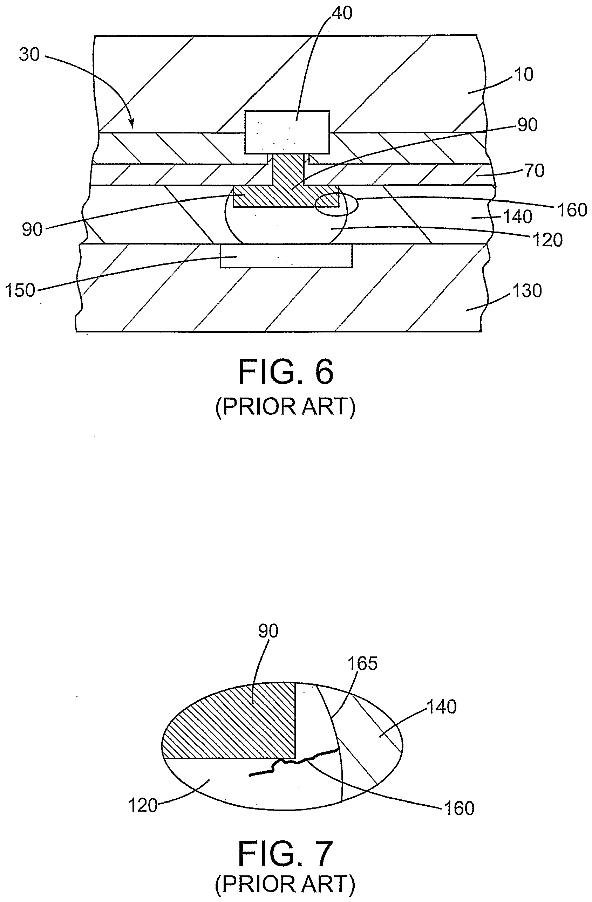

As noted in the Background section hereof, the placement of the polyimide layer 70 beneath the metallization layer 90 has an important ramification that is evident when the semiconductor device 10 is flip-chip mounted on another device. In this regard, FIG. 6 depicts a sectional view of the semiconductor device 10 flip-chip mounted on another substrate 130 such that the side 30 faces downward. An underfill material 140 is disposed between the polyimide layer 70 and the substrate 130 to lessen the stresses due to differences in the coefficients of thermal expansion of the electrical device 130 and the semiconductor device 10. The solder bump of the semiconductor device 10 is positioned on a corresponding bond pad 150 of the device 130. In this way, an electrical pathway is established between the bond pad 40 of the device 10 and the bond pad 150 of the device 130 via the metallization layer 90 and the solder bump 120. A small portion of the solder bump 120, the underfill layer 140 and the metallization layer 90 is circumscribed by a small oval 160. The portion circumscribed by the oval 160 is shown at greater magnification in FIG. 7.

FIG. 7 illustrates a drawback to the placement of the polyimide layer 70 shown in FIG. 6 between the metallization layer 90 and the solder bump 120. A crack 160 is shown in the solder bump 120 that extends from the border 165 with the underfill material 140 toward the central portion of the solder bump 120. The crack 160 is the result of thermal stresses that are not adequately compensated for by virtue of the relative stiffness of the lead-free solder bump 120 and the relative distance of the polyimide layer 70 from the area where the crack 160 forms. The crack 160 may propagate across the entire width of the solder bump 120 and produce an open circuit.

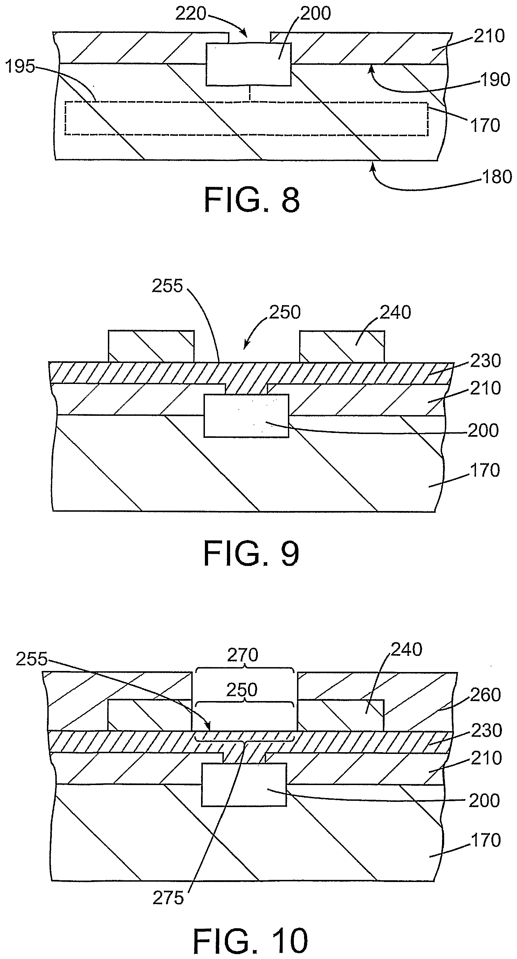

An exemplary novel fabrication process that overcomes the pitfalls of the above-described conventional process may be understood by referring now to FIGS. 8-12, which depict successive sectional views of an integrated circuit or semiconductor device 170 undergoing various process steps leading to the formation of a solder bump. It should be understood that FIGS. 8-12 depict just a small portion of the device 170. The semiconductor device 170 may be any of a myriad of different types of circuit devices used in electronics, such as, for example, microprocessors, graphics processors, application specific integrated circuits, memory devices or the like, and may be single or multi-core.

Structurally speaking, the device 170 has opposing sides 180 and 190. Device circuitry, represented schematically by the dashed box 195, may be located proximate the side 190. To connect the circuitry 195 electrically to external devices, the semiconductor device 170 may be provided with multiple conductor or bond pads, one of which is shown and labeled 200, that are positioned proximate the side 190. Depending on the complexity and size of the semiconductor device 170, there may be scores of the pads 200. The bond pad 200 may be composed of a variety of conductor materials, such as aluminum, copper, silver, gold, titanium, refractory metals, refractory metal compounds, alloys of these or the like. The bond pad 200 may be formed by plating, physical vapor deposition pr other material deposition techniques.

A passivation layer 210 is formed on the side 190 with an opening 220. The passivation layer 210 is designed to inhibit the diffusion of metallic or other materials down into the semiconductor device 170. The layer 210 may be composed of a variety of insulating materials, such as, for example, silicon nitride, silicon dioxide, various silicate glasses or the like. The opening 220 may be formed by well-known lithographic patterning and etching techniques.

For simplicity of illustration, the remaining figures do not include the circuitry 195. Attention is now turned to FIG. 9. A conductor or metal layer 230 is formed on the passivation layer 210 and in the opening 220 thereof so that ohmic contact is established with the bond pad 200. The metallization layer 230 is designed to provide a conducting interface between the bond pad 200 and a subsequently formed solder structure (not shown). The metallization layer 230 may be composed of a variety of conductor materials, such as aluminum, copper, silver, gold, titanium, refractory metals, refractory metal compounds, alloys of these or the like. In lieu of a unitary structure, the layer 230 may consist of a laminate of plural metal layers, such as a titanium layer followed by a nickel-vanadium layer followed by a copper layer. Alternatively, a titanium layer may be covered with a copper layer followed by a top coating of nickel. However, the skilled artisan will appreciate that a great variety of conducting materials may be used for the metallization layer 230. Various well-known techniques for applying metallic materials may be used, such as physical vapor deposition, chemical vapor deposition, plating or the like. It should be understood that additional conductor structures could be interposed between the metal layer 230 and the conductor pad 200.

An insulating film 240 is deposited on the stack consisting of the metallization layer 230, the passivation layer 210, the pad 200 and the semiconductor device 170. The insulating film 240 is positioned on a surface 255 of the metal layer 230. The layer 240 is intended to provide passivation and cushion against differences in thermal expansion of the semiconductor device 170, the metallization layer 230 and the subsequently formed solder bump (not shown). Exemplary materials for the insulating layer 240 include, for example, polymeric materials such as polyimide and benzocyclobutene or the like, or other insulating materials such as silicon nitride or the like. Spin coating, chemical vapor deposition or other deposition processes may be used. The insulating layer 240 is patterned lithographically with an opening 250 that exposes a portion of the metallization layer 230. Note that the insulating layer 240 is positioned above the metallization layer 230 as opposed to below the metallization layer 90 in the conventional technique depicted in FIGS. 1-5. This placement provides a structural advantage as described in more detail below.

Attention is now turned to FIG. 10. A mask film 260 is deposited on the stack consisting of the insulating layer 240, the metallization layer 230, the passivation layer 210, the pad 200 and the semiconductor device 170. The mask film 260 is patterned lithographically with an opening 270 that is concentric with the opening 250 in the insulating layer 240. Together, the openings 250 and 270 leave a portion 275 of the surface 255 of the metal layer 230 exposed. In a subsequent process, a conductor material is positioned in the combined openings 250 and 270 to establish ohmic contact with the metallization layer 230 and the underlying bond pad 200 of the device 170. The film 260 may be made from, for example, a rubberized epoxy resin with phenol resin, fused silica and synthetic rubber. Optionally, other materials suitable for a metal application mask may be used.

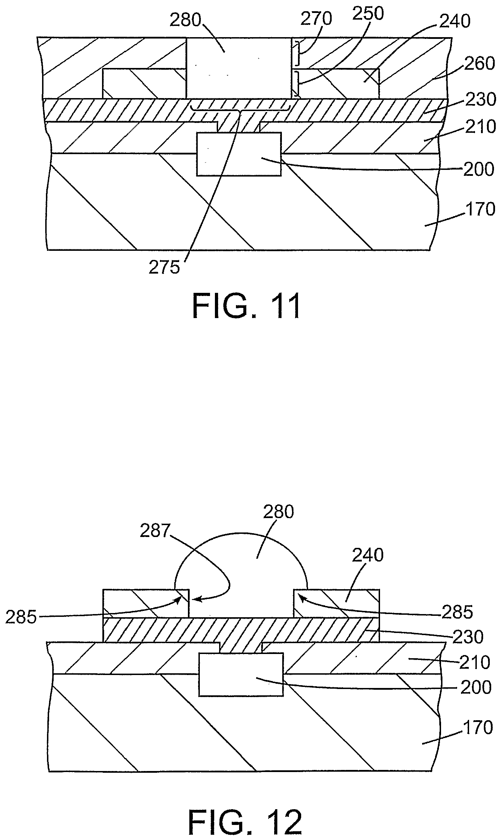

As shown in FIG. 11, the semiconductor device 170 is subjected to a plating process to deposit a conductor material 280 in the openings 250 and 270 and on the exposed portion 275 of the surface 255 of the metallization layer 230. The film 260 serves as a mask against this deposition process. The conductor 280 may be a lead-based solder or lead free as desired. Exemplary materials include, for example, tin-copper, tin-silver, or other solder materials. The conductor material 280 borders the insulating layer 240. At this point, a conductive pathway between the bond pad 200, the metallization layer 230 and the conductor material 280 exists. The passivation layer 210 is unaffected. Of course, another conductor(s) (not shown) may be positioned between the conductor 280 and the bond pad 200 and still provide the desired ohmic pathway.

As shown in FIG. 12, the film 260 depicted in FIG. 11 is removed and a reflow process is performed to reflow the conductor 280 into a ball or bump-like structure. In an exemplary example, the semiconductor device 170 may be heated to about 170 to 190°C for about 10 to 120 seconds. The appropriate parameters for the reflow will depend on the composition of conductor material 280. Unwanted portions of the metallization layer 230 are removed by a chemical etch process. Thus, portions of the passivation layer 210 lateral to the conductor 280 are exposed. A conductive pathway exists between the conductor 280 and the bump bond pad 200 by way of the metallization layer 230. Note that the conductor 280 is positioned on a portion 285 of the insulating layer 240. The portion 285 provides a stress reducing interface with a peripheral corner 287 of the conductor 280.

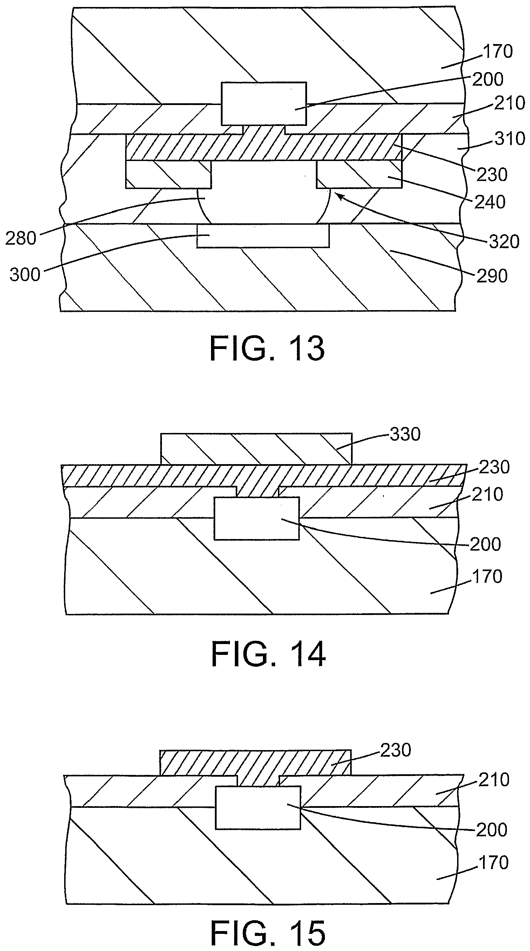

The advantages of the new positioning of the insulating layer 240 are evident when the device 170 is mounted to another substrate. Attention is now turned to FIG. 13, which depicts the semiconductor device 170 mounted on another electrical device 290. The electrical device 290 may be a printed circuit board, or other electrical device as desire. FIG. 13 depicts a flip-chip mounting arrangement in which the device 170 is flipped over and mounted on the electrical device 290 so that the solder structure 280 is seated on a bond pad 300 of the electrical device 290. It should be understood that the device 290 may include scores of such pads 300 to receive corresponding bumps 280 of the device 170. If desired, the pads 300 may be fitted with small solder bumps (not shown) designed to meld with solder structure(s) 280 during a subsequent reflow. An underfill material 310 is dispersed between the device 170 and the electrical device 290 to reduce the effects of differences in the coefficients of thermal expansion of the device 170 and the device 290. The underfill 310 may be, for example, an epoxy resin mixed with silica fillers and phenol resins. Because the insulating layer 240 is positioned between the metallization layer 230 and the solder structure 280, an additional compliant cushioning effect is provided for the corner 320 of the solder bump 280 against the types of thermal stresses and cracking associated with the conventional structure depicted in FIGS. 6 and 7. Note that the corner 320 extends around the entire periphery of the solder structure 280.

In the foregoing illustrative example, a plating process may be used to form the solder structures 280. In an alternate exemplary process depicted in FIGS. 14-18, a stencil process may be used to establish a solder structure. Turning initially to FIG. 14, the semiconductor device 170 may be processed as described elsewhere herein to provide the bond pad 200, the passivation layer 210 and the metallization layer 230. At this stage, an etch mask 330 of resist or other mask material is formed on the metallization layer 230, and an etch is performed on the metallization layer 230 to trim portions thereof lateral to the bond pad 200 and expose portions of the passivation layer 210 as shown in FIG. 15. The etch mask 330 may be removed by ashing, solvent stripping or the like. When viewed from above, the metallization layer 230 may be circular or another shape as desired. The bond pad 200 is unaffected by the etch or mask strip.

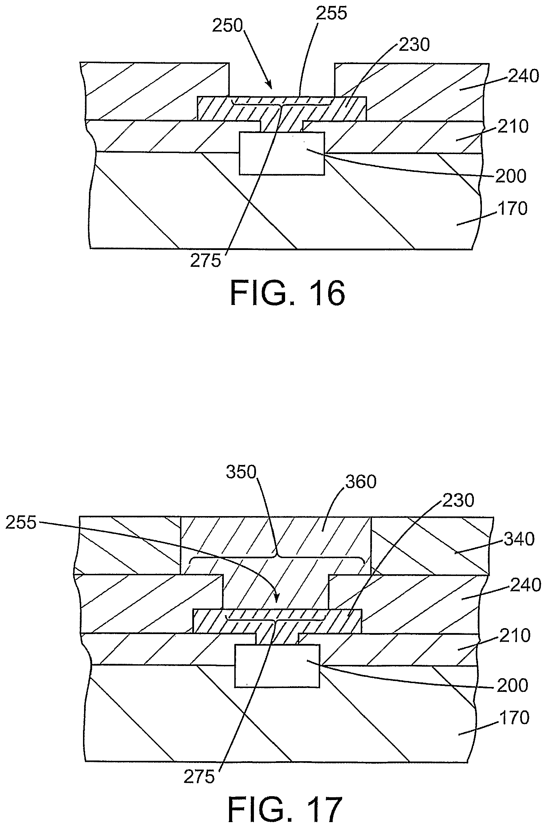

As shown in FIG. 16, the insulating layer 240 is formed on the stack consisting of the metallization layer 230, the passivation layer 210, the bond pad 200 and the semiconductor device 170 as generally described elsewhere herein. The insulating layer 240 has the aforementioned opening 250 leading to the metallization layer 230 and leaving the surface thereof 255 with an exposed portion 275.

Referring now to FIG. 17, a stencil 340 is formed on the stack consisting of the insulating layer 240, the metallization layer 230, the passivation layer 210, the bond pad 200 and the semiconductor device 170. The stencil 340 includes an opening 350 over the metallization layer 230 and portions of the insulating layer 240. The stencil 340 may be fabricated from, for example, a rubberized epoxy resin with phenol resin, fused silica and synthetic rubber. Optionally, other materials suitable for metal application stencils may be used. A conductor paste 360 is pressed into the opening 350 of the stencil 340. The conductor paste 360 is positioned on the exposed portion 275 of the surface 255 of the metal layer 230 and a portion 365 of the insulating layer 240. The paste 360 may be composed of the same materials used for the solder bump 280 described elsewhere herein. Of course, another conductor(s) (not shown) may be positioned between the conductor 360 and the bond pad 200 and still provide the desired ohmic pathway.

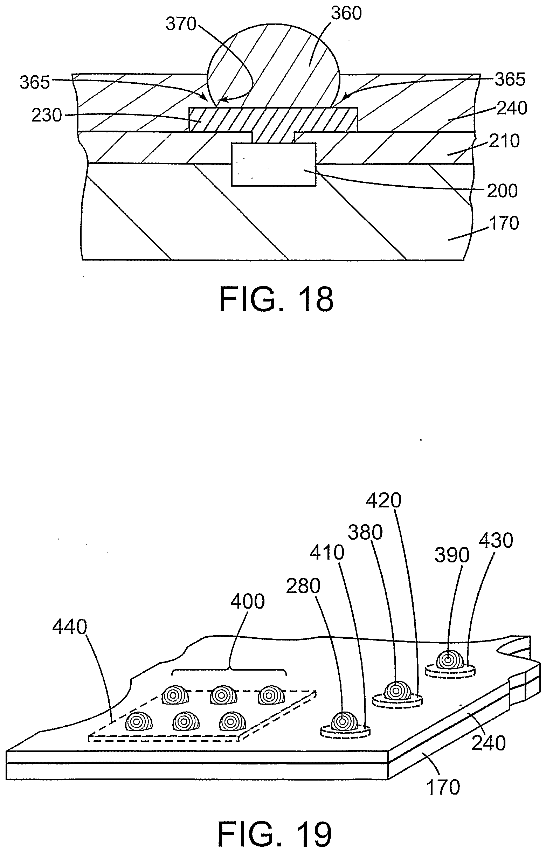

To complete the process, the stencil 340 is removed and a thermal reflow process is performed to reshape the conductor paste 360 into a bump that metallurgically bonds to the pad 200 as shown in FIG. 18. In an exemplary example, the semiconductor device 170 may be heated to about 170 to 190°C for about 10 to 120 seconds. The appropriate parameters for the reflow will depend on the composition of conductor paste 360. The passivation layer 210 is unaffected. The conductor 360 is positioned on a portion 365 of the insulating layer 240. As in the above-described example, the insulating layer 240 provides enhanced structural protection for a peripheral corner 370 of the solder bump 360.

In addition to providing improved structural protection for the solder bumps 280, 360 etc., the positioning of the insulating layer 240 as disclosed herein enables the under bump metallization layer 230 to serve as an electrical routing structure. An exemplary example may be understood by referring now to FIG. 19, which is a pictorial view of a portion of the semiconductor device 170 positioned with the insulating layer 240 and several bumps facing upwardly. One of the bumps is labeled 280 as in FIGS. 8-12. Two other bumps are separately labeled 380 and 390. A group of six bumps are collectively labeled 400. The bumps 280, 380 and 390 may be formed and provided with discrete under bump conductor structures or metal layers 410, 420 and 430 that are structurally isolated using the techniques disclosed herein. The metal layers 410, 420 and 430 are covered by the insulating layer 240 and thus shown in phantom. However, the group of bumps 400 may be formed using the techniques disclosed herein, but with a common under bump conductor structure or metal layer 440 that is covered by the insulating layer 240 and thus also shown in phantom. The insulating layer 240 is thus formed with plural openings to expose plural portions of the metal layer 440 prior to formation of the bumps 400. In this way, the metal layer 440 can serve as a routing structure for the group of bumps 400. This may be advantageous where several bumps are dedicated temporarily or permanently to one type of input/output, such as power or ground. Because the insulating layer 240 is positioned between the group 400 of bumps and the metallization layer 440, selected bumps can be tied together without risk that solder will seep laterally and make unwanted shorts during reflow. Of course, the number and groupings of bumps and shaping of the common under bump metallization layer(s) 440 are subject to great variation.

The skilled artisan will appreciate that the exemplary processes disclosed herein may be performed concurrently on multiple dice that are arranged in a wafer. Thereafter, singulation may be performed. Optionally, an individual die may be processed after singulation.

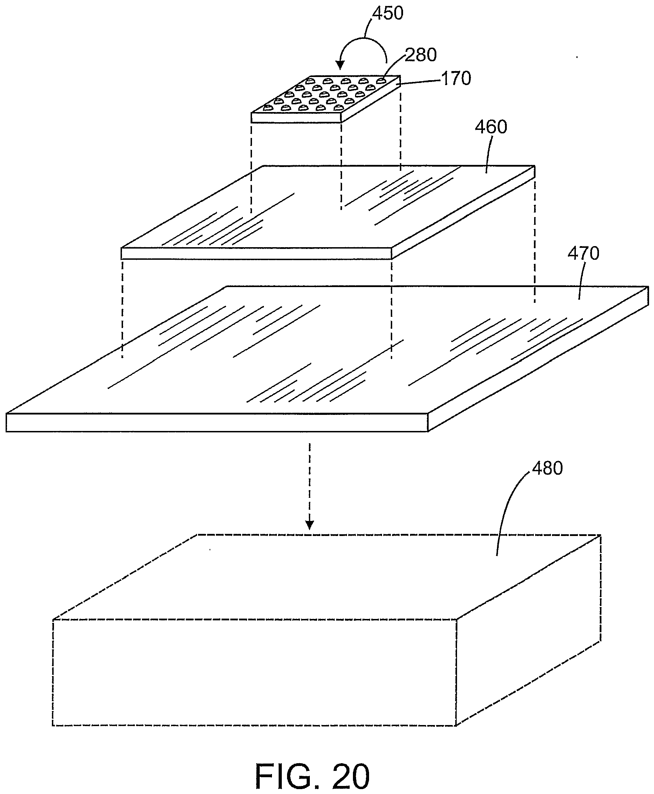

The semiconductor device 170 may be mounted in a variety of ways. FIG. 20 depicts an exploded pictorial view of a few exemplary mounting possibilities. The semiconductor device 170 is depicted with the solder bumps 280 facing upwards. The device 170 may be flipped over as indicated by the arrow 450 and flip-chip mounted on a substrate 460. The substrate 460 may be a package substrate, a printed circuit board or other type of substrate. If configured as a package substrate, the substrate 460 may be a pin grid array, a ball grid array, a land grid array, a surface mount or other type configuration. The substrate 460 may be mounted to another substrate 470. The substrate 470 may be a printed circuit board or other type of substrate. For example, the substrate 470 may be a motherboard for a computer system. The semiconductor device 170 may be included in a larger system, such as a computing device represented by the dashed box 480. The computing device 480 may be include, for example, a digital television, a handheld mobile device, a personal computer, a server, a memory device, an add-in board such as a graphics card, or any other computing device employing semiconductors.

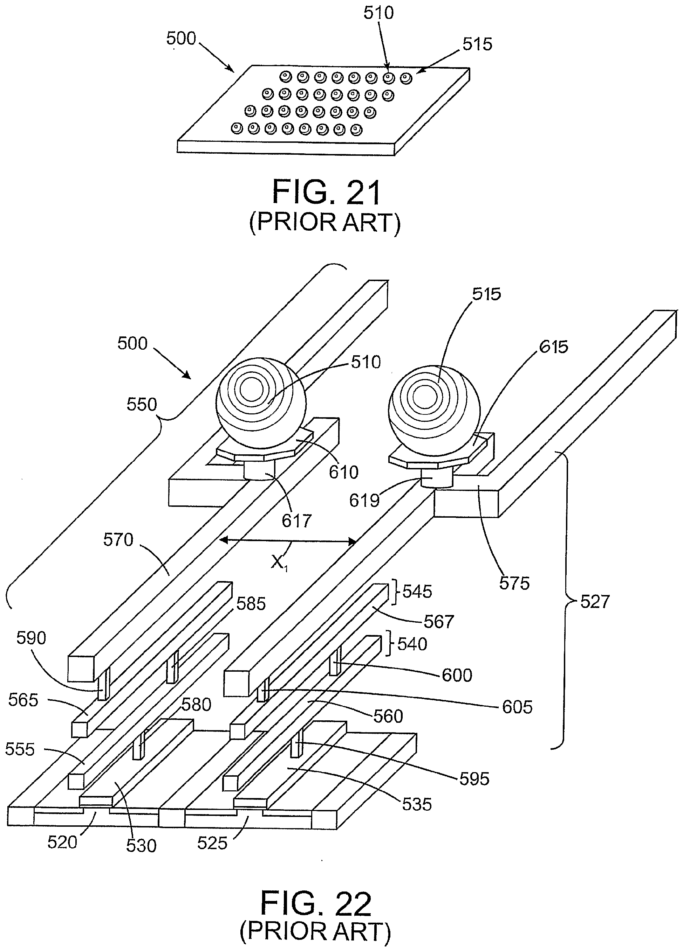

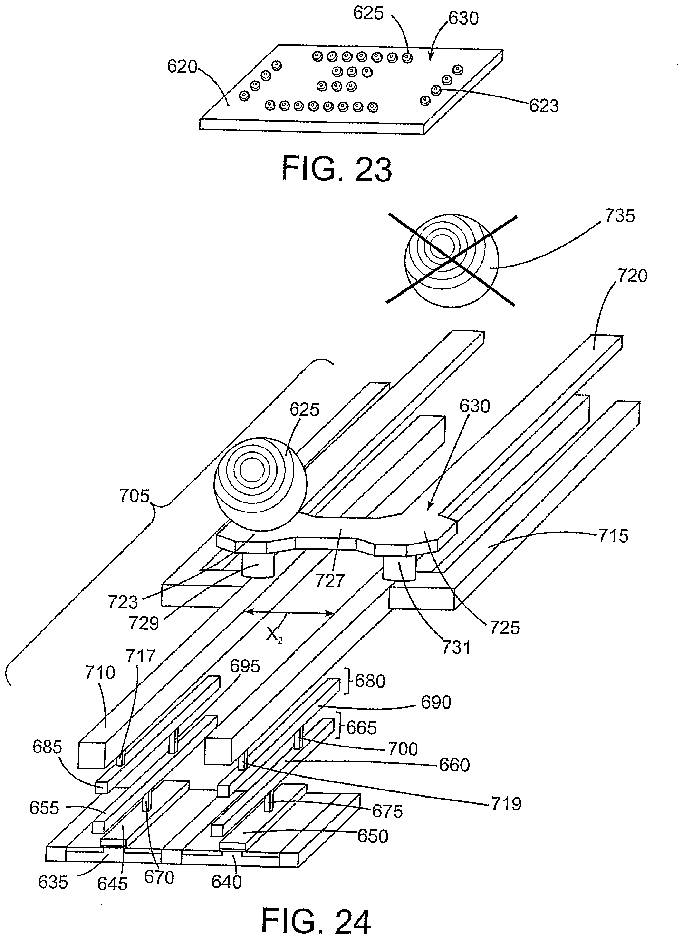

FIG. 19 discussed above illustrated an example of the use of a UBM structure for electrical routing. Several examples of complex routing using UBM arrangements are depicted in FIGS. 23-30. Before turning to a discussion of those figures, it will be useful to briefly review a conventional electrical routing design for a semiconductor chip that utilizes solder structures for input/output. FIG. 21 is a pictorial view of an exemplary conventional semiconductor chip 500 positioned bottom side up so that a plurality of conductor balls are visible. Two of the balls are labeled 510 and 515. During mounting to a printed circuit board (not shown), the chip 500 is flipped over so that the balls 510, 515, etc. face downward and establish metallurgical connections with corresponding solder structures on the printed circuit board. The solder balls 510, 515, etc. are interconnected to various circuit structures in the body of the chip 500 that are not visible in FIG. 21. However, some exemplary interconnect structures between the solder balls 510 and 515 and circuit structures in the chip 500 are shown at much greater magnification in FIG. 2.

Attention is now turned to FIG. 22, which is a pictorial view of the two solder balls 510 and 515 depicted in FIG. 21 as well as typical interconnect structures leading from the solder balls 510 and 515 down to two exemplary conventional electronic devices 520 and 525 in the chip 500. It should be understood that the various insulating layers that are present in the area 527 between the solder balls 510 and 515 and the electronic devices 520 and 525 are not shown so that details of the electrical interconnects between the devices 520 and 525 and the balls 510 and 515 are clearly visible. The electronic devices 520 and 525 are depicted as field effect transistors that have respective gates 530 and 535. Two metallization layers 540 and 545 and a redistribution layer (RDL) 550 are interposed between the solder balls 510 and 515 and the electronic devices 520 and 525. The metallization layer 540 consists of some plurality of metal lines, two of which are shown and labeled 555 and 560. The metallization layer 545 similarly consists of a plurality of metal lines, two of which are shown and labeled 565 and 567 and the RDL 550 consists of a plurality of metal lines two of which are shown and labeled 570 and 575. The metal structure 555 is electrically connected to the gate 530 of the device 520 by way of a contact 580. The metal structures 555 and 565 are connected electrically by a via 585 and the RDL structure 570 is electrically connected to the metal layer structure 565 by way of a via 590. A contact 595 and two vias 600 and 605 are provided to electrically link up the RDL structure 575 to the gate 535 of the device 525. The solder balls 510 and 515 are electrically connected to the respective RDL structures 570 and 575 by way of respective UBM ball or bond pads 610 and 615, and conductor extensions 617 and 619.

The RDL 550 is designed to provide extra flexibility in the routing and layout for the solder balls 510 and 515 as well as the other solder balls shown in FIG. 1. Because the solder balls are typically fabricated with some risk of initial misalignment or spill over and consequent short circuiting during thermal reflow, a certain minimum pitch, X₁, between the RDL structures 570 and 575 of the RDL 550 must be maintained in order to lessen the chances of such cross contamination and short circuiting.

An exemplary example of a semiconductor chip or device that incorporates a UBM layer for complex routing may be understood by referring now to FIGS. 23 and 24. FIG. 23 is a pictorial view of an exemplary example of a semiconductor chip or device 620 that is shown bottom side up to reveal a plurality of solder structures, two of which are labeled 623 and 625. The chip 620 may include scores, hundreds or thousands of solder structures. However, for simplicity of illustration, only a few such solder structures are shown in FIG. 23. Note that there is no solder structure at the location labeled 630. The significance of this omission will be explained in detail in relation to FIG. 24. The semiconductor device 620 may be any of a myriad of different types of circuit devices used in electronics, such as, for example, microprocessors, graphics processors, application specific integrated circuits, memory devices or the like, and may be single or multi-core.

Attention is now turned to FIG. 24, which depicts, in pictorial form and at higher magnification, both the solder structure 625 and the location 630 of the semiconductor chip 620 depicted in FIG. 23 removed from the chip 620. Two of the perhaps millions of circuit devices in the semiconductor chip 620 are depicted in FIG. 24 and labeled 635 and 640, respectively. The circuit devices 635 and 640 are depicted as field effect transistors, however, they may be any of a myriad of different types of circuit devices used in integrated circuits. The transistors 635 and 640 have respective gates 645 and 650 that are connected to respective metal lines 655 and 660 of a metallization layer 665 by way of contacts 670 and 675. A second metallization layer 680 consists of metal lines 685 and 690 connected to the metal layer 665 by way of vias 695 and 700. While only two metallization layers 665 and 680 are depicted, there may be many more depending on the complexity of the semiconductor chip 620.

A RDL 705 consisting of a plurality of RDL structures, two of which are shown and labeled 710 and 715, is provided to establish electrical routing between the solder balls 623 (see FIG. 23) and 625 and the underlying circuit devices. The RDL 705 is advantageously composed of many conductor lines that are advantageously fabricated with relatively large sizes and/or other properties that provide preferentially low ohmic losses. The RDL structure 710 is connected to the metal line 685 by way of a via 717 and the RDL structure is connected to the metal line 690 by way of a via 719. Up to this point, the structure depicted in FIG. 24 is nearly identical to the conventional solder ball and electrical routing structure depicted in FIG. 22. However, in this illustrative example a conductor or UBM structure 720, which may be part of a much more expansive UBM layer, is interposed between and electrically connected to the solder ball 625 and the RDL structures 710 and 715. The UBM structure 720 includes pads or sites 723 and 725 that are tied together by a cross-member 727 and connected to the RDL structures 710 and 715 by two extension members 729 and 731, respectively. In this way, a solder ball 735 that would ordinarily have to be positioned at the location 630 on the pad 725 to provide an input/output for the pad RDL structure 715 may be eliminated. Since the solder ball 735 may be eliminated, the RDL structures 710 and 715 may be squeezed closer together with a minimum pitch, X₂, that can be less than the minimum pitch, X₁, for the conventional structure depicted in FIG. 22. The pad sites 723 and 725 of the UBM structure 720 are commonly electrically connected to the gates 645 and 650 of the transistors 635 and 640. Accordingly, the UBM structure 720 should be used to commonly tie ball/bump sites that are dedicated to the same type of electrical signal, e.g., power, ground or signal as the case may be. While the UBM structure 720 is depicted as a simple horseshoe shaped device, it should be understood that the UBM structure 720 may take on a great variety of different configurations and may be accompanied by a large number of similar UBM structures that are used to tie in various ways the various conductor bumps depicted on the semiconductor chip 620 in FIG. 23. It should be understood that the UBM structure 720 may be fabricated using the techniques and materials disclosed elsewhere herein.

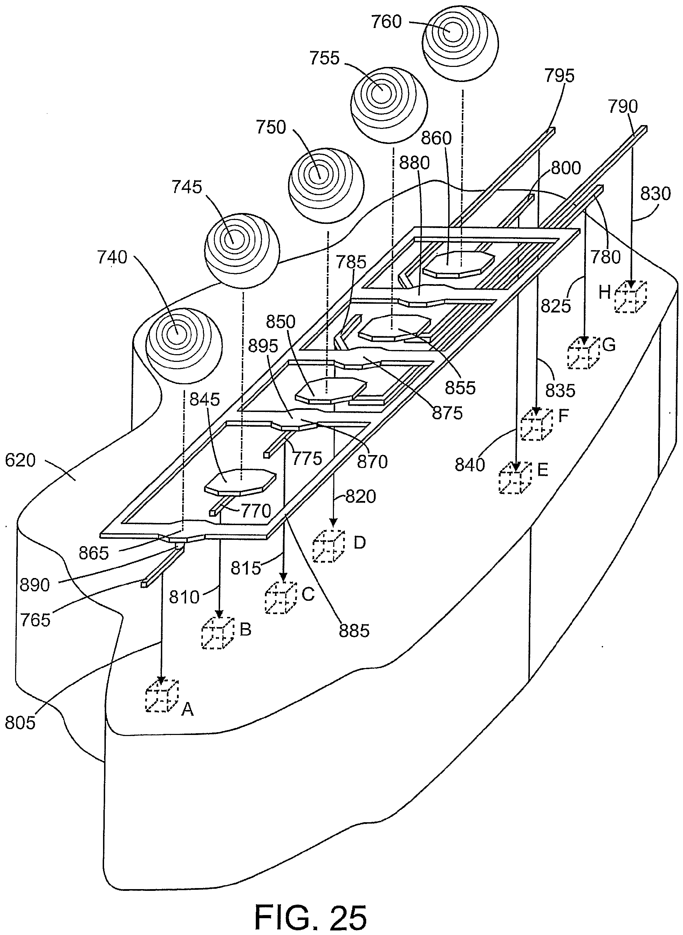

Attention is now turned to FIG. 25, which is a pictorial view of a small portion of the semiconductor chip 620 depicted in FIG. 23 along with a few solder balls 740, 745, 750, 755 and 760 exploded from the chip 620. A few of the myriad of internal circuit structures of the semiconductor chip 620 are represented schematically by the dashed boxes A, B, C, D, E, F, G and H. The circuit structures A, B, C, D, E, F, G and H may be, for example, power rails, ground rails, capacitors, larger integrated circuit functional blocks, memory devices, processor cores or virtually anything else that is utilized in a semiconductor chip. The circuit structures A, B, C, D, E, F, G and H are electrically connected to respective RDL structures 765, 770, 775, 780, 785, 790, 795 and 800 by way of respective interconnects that are represented schematically by the arrow-ended lines 805, 810, 815, 820, 825, 830, 835 and 840. The interconnects 805, 810, 815, 820, 825, 830, 835 and 840 may consist of one or more metallization or other conductor material layers, such as the multiple metallization layers 665 and 680 depicted in FIG. 24. Conductor pads 845, 850, 855 and 860 are connected to the RDL structures 770, 780, 790 and 800, respectively. The solder balls 745, 750, 755 and 760 are mounted to the conductor pads 845, 850, 855 and 860.

Conductor pads 865, 870, 875 and 880 are connected to the RDL structures 765, 775, 785 and 795, respectively. The conductor pads 865, 870, 875 and 880 are tied together electrically and fabricated as part of a UBM structure 885 that is fashioned as a grid-like structure. The UBM structure 885 may be connected to the underlying RDL structures 765, 775, 785 and 795 by respective extensions, one of which is visible proximate the pad site 865 and labeled 890. Indeed, the pads 845, 850, 855 and 860 may use similar extensions that are not visible. The solder ball 740 is connected to the UBM structure 885 at the pad 865. In this way, an electrical input/output via the solder ball 740 is provided for all of the bond pads 865, 870, 875 and 880 and thus the underlying circuit structures A, C, D and F. A grid-like structure for the UBM structure 885 has the advantage of a relatively simple layout that may be easily patterned lithographically and formed using well-known techniques. In addition, such a structure provides a relatively efficient delivery of current and thus relatively small ohmic losses. Since all of the conductor pads 865, 870, 875 and 880 are commonly connected and part of the UBM structure 885, those bond pads will typically be dedicated to a particular type of electrical input/output, such as ground, power or signal. The other pads 845, 850, 855 and 860 may be connected as input/outputs for power, ground or signal as the case may be. Of course, all the pads 845, 850, 855, 860, 865, 870, 875 and 880 may be fabricated on the same level for simplicity of manufacturing.

The UBM structure 885 enables the elimination of solder balls that would ordinarily have to be placed at the pad at the pads 870, 875 and 880. Thus, the overall arrangement of the remaining solder balls 740, 745, 750, 755 and 760 may be compacted accordingly.

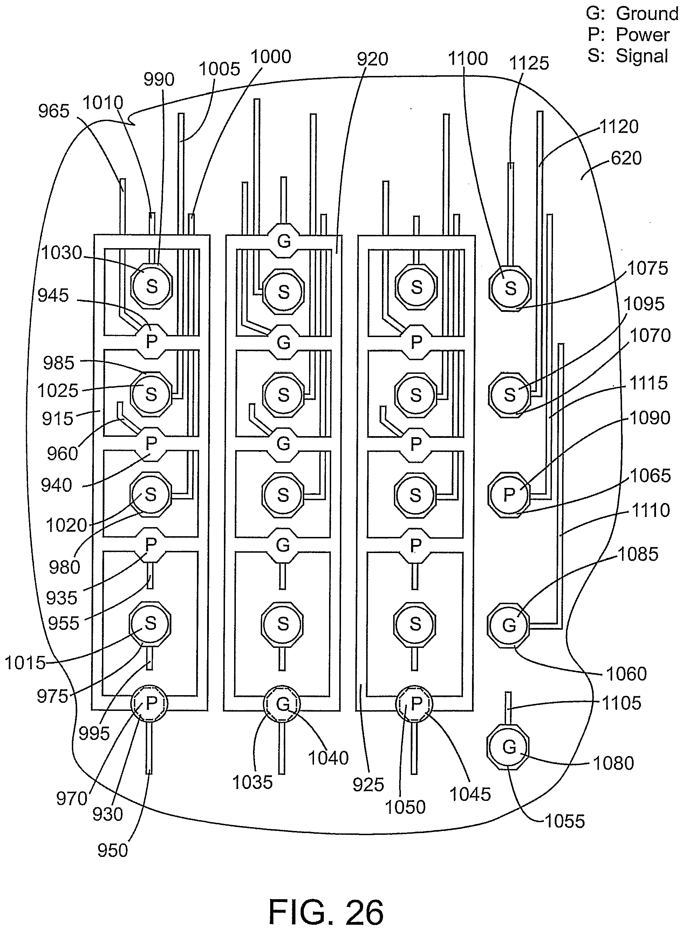

Considerable flexibility is envisioned for the potential routing available with the disclosed UBM structures. Attention is now turned to FIG. 26, which is a plan view of a small portion of the chip 620. Here, three grid-type UBM structures 915, 920 and 925, that may be part of some more expansive UBM layer, are depicted without any insulating material that is in and around them for simplicity of illustration. Turning first to the location associated with the UBM structure 915, conductor pads 930 (shown in phantom), 935, 940 and 945 are shown connected to respective RDL layer structures 950, 955, 960 and 965. The redistribution layer structures 950, 955, 960 and 965 are positioned beneath the pads 930, 935, 940 and 945 and electrically connected to other interconnect or circuit structures that are inside the semiconductor chip 620. The conductor pads 930, 935, 940 and 945 are tied to power pathways of the chip 620 and thus slated for the input/output of power as suggested by the "P" label. However, the inclusion of the UBM structure 915 enables the input/output of power for all of the pads 930, 935, 940 and 945 to be routed up through a single solder ball 970 positioned proximate the conductor pad 930. Several other conductor or bond pads 975, 980, 985 and 990 may be nested in and around the UBM structure 915, tied to signal pathways of the chip 620 and slated for the input/output of, for example, signals as suggested by the "S" label. In this regard, the pads 975, 980, 985 and 990 may be tied electrically to respective RDL structures 995, 1000, 1005 and 1010 and provided with respective solder balls 1015, 1020, 1025 and 1030.

In like fashion the UBM structure 920 may be configured to route multiple locations of ground pathways, as suggested by the "G" label, to a bond pad 1035 shown in phantom, and a corresponding solder ball 1040, and the UBM structure 925 may be configured to route multiple sites of power input/output to a conductor pad 1045 (shown in phantom) and a solder bump 1050. Of course, the UBM structures 915, 920 and 925 may be used in conjunction with multiple conductor pads 1055, 1060, 1065, 1070 and 1075 that are each provided with respective solder bumps 1080, 1085, 1090, 1095 and 1100 where the conductor pads 1055, 1060, 1065, 1070 and 1075 are ohmically connected to respective RDL structures 1105, 1110, 1115, 1120 and 1125. This arrangement may be appropriate where, for example, the conductor pads 1055 and 1060 are slated for ground input/output, the conductor pad 1065 is slated for power input/output and the conductor pads 1070 and 1075 are slated for signal input/output. An important point is that both traditional solder bump-to-RDL interconnects may be used along with the UBM routing structures to achieve a desired layout pattern.

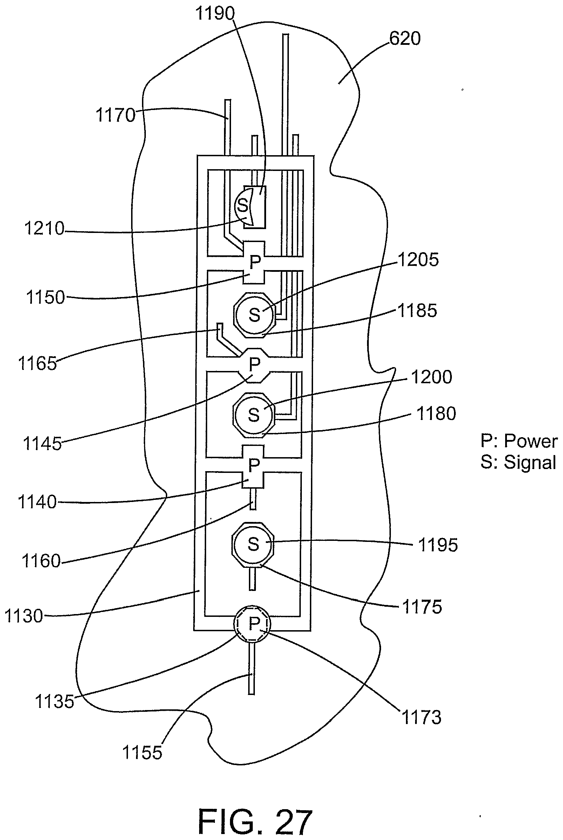

Attention is now turned to FIG. 27, which is a plan view of another portion of the semiconductor chip 620. In this portion, a UBM structure 1130 is visible along with a set of conductor pads 1135 (shown in phantom), 1140, 1145 and 1150 electrically connected to and forming part of the UBM structure 1130. The UBM structure 1130 and the pads 1135, 1140, 1145 and 1150 are depicted without any surrounding and covering insulating material for simplicity of illustration. The conductor pads 1135, 1140, 1145 and 1150 may be tied to respective RDL structures 1155, 1160, 1165 and 1170. The conductor pads 1135, 1140, 1145 and 1150 may be slated for the input/output of power via a single bump 1173 connected to the UBM 1130 proximate the pad 1135 as shown. In addition, other pads 1175, 1180, 1185 and 1190 may be provided and slated for the input/output of signals. Solder bumps 1195, 1200, 1205 and 1210 may be provided on the pads 1175, 1180, 1185 and 1190, respectively. Note that a portion of the bump 1210 is shown cut away to reveal additional detail of the conductor pad 1190. In this illustrative example the bond pad 1190 may be configured as a rectangular structure as opposed to a circular or octagonal structure as disclosed elsewhere herein. A rectangular structure has the advantage of enabling a tighter packing of conductor pads and their associated RDL structures. Indeed, the conductor pads 1140 and 1150 that are electrically connected to the UBM structure 1130 are depicted as rectangular structures as well.

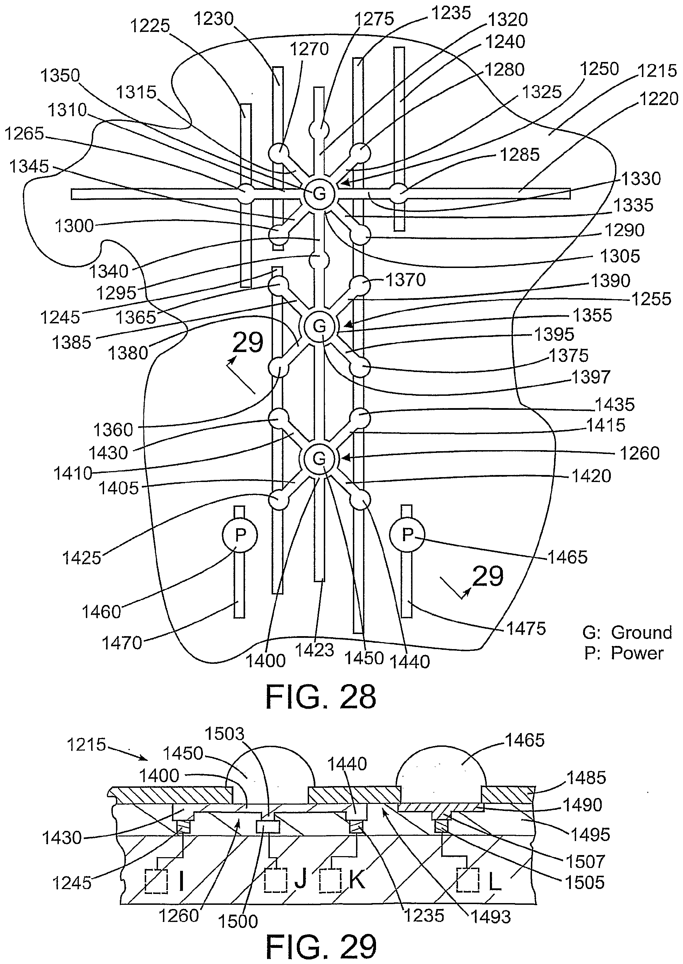

A plan view of another illustrative embodiment of a semiconductor chip 1215 is shown in FIG. 28. Only a small portion of the semiconductor chip 1215 is depicted and without any surrounding and covering insulating material for simplicity of illustration. An exemplary UBM structure 1220 is shown positioned over several RDL structures 1225, 1230, 1235, 1240 and 1245. The UBM structure 1220 may be provided with several clusters 1250, 1255 and 1260 of lead structures. The cluster 1250 may consist of a plurality of leads 1265, 1270, 1275, 1280, 1285, 1290, 1295 and 1300 that are connected to a central hub 1305 by respective spokes 1310, 1315, 1320, 1325, 1330, 1335 and 1340. The spokes need not terminate at their respective leads as is the case for the spokes 1310, 1320, 1330 and 1340. The lead 1265 is electrically connected to the underlying RDL structure 1225, the leads 1270 and 1300 are connected to the underlying RDL structure 1230, the leads 1280 and 1290 are connected to the underlying RDL structure 1235 and the lead 1285 is connected to the underlying RDL structure 1240. The hub 1305 may be provided with a solder bump 1350 that may be slated for ground input/output.

The cluster 1255 may include a hub 1355 and a plurality of leads 1360, 1365, 1370 and 1375 that extend away therefrom but are connected thereto by respective spokes 1380, 1385, 1390 and 1395. The leads 1360 and 1365 are connected to the underlying RDL structure 1245 and the leads 1370 and 1375 are connected to the underlying RDL structure 1235. The cluster 1255 may be tied to the cluster 1250 at the lead 1295 as shown or at some other point as desired. A solder ball 1397 may be connected to the hub 1355.

Finally, the cluster 1260 may consist of a hub 1400, spokes 1405, 1410, 1415, 1420 and 1423 and leads 1425, 1430, 1435 and 1440 connected to the spokes 1405, 1410, 1415, 1420, respectively. The leads 1425 and 1430 may be connected to the underlying RDL structure 1245 and the leads 1435 and 1440 may be connected to the underlying RDL structure 1235. Like the clusters 1250 and 1255, the cluster 1260 may be provided with a solder bump 1450 that is slated for ground input/output. The power bumps 1460 and 1465 are connected to underlying RDL structures 1470 and 1475. Before turning to FIG. 29, it is important to note the location of

Attention is now turned to FIG. 29, which is a sectional view of FIG. 28 taken at section 29-29. Before examining FIG. 29 in detail, it should be noted that: (1) section 29-29 passes through the lead 1430, the hub 1400 and solder ball 1450 combination, the lead 1440 and the solder ball 1465; and (2) FIG. 29 does depict some of the details of the semiconductor chip 1215 that were not depicted in FIG. 28 so that the other details of various conductor structures and UBM structures could be observed. Thus, for example, the two solder bumps 1450 and 1465 are separated laterally and electrically insulated laterally by way of a polyimide or other polymeric material film 1485. Again, it should be remembered that the film 1485 is not depicted in FIG. 28 so that other structures described therewith are not obscured. In particular, there is a UBM structure 1490 beneath the solder ball 1465 that is separately laterally from the UBM cluster 1260 by a gap 1493. The gap 1493 is filled with an insulating material that is part of an insulating material layer 1495. The insulating material layer 1495 may be configured like the passivation layer described in conjunction with other embodiments discussed elsewhere herein. As noted elsewhere herein, ohmic contact is established between the solder ball 1450 and the underlying UBM structure, in this case, the hub 1400. The hub 1400 is, in turn, in ohmic contact with an underlying RDL structure 1500, that is not visible in FIG. 28, by way of a lead or extension 1503. The leads 1430 and 1440 are in ohmic contact with the underlying RDL structures 1245 and 1235. The RDL structures 1245, 1500 and 1235 are electrically connected to circuit structures represented by the dashed boxes I, J and K that are located deeper in the semiconductor chip 1215. The circuit structures I, J and K may be of the type generally described above in conjunction with the circuit structures A, B, C, D, etc. in FIG. 25. The solder bump 1465 is in ohmic contact with an underlying UBM structure 1490, which is, in turn, in ohmic contact with an RDL structure 1505 by way of an extension or lead 1507 that is not visible in FIG. 28. The RDL structure 1505 is connected to the underlying circuit represented by the dashed box L, which may be configured as described above with regard to the circuit structures I, J and K.

A cluster structure may be used for power, ground or signal. Whether used for power, ground or signal input/output, the benefit of using a cluster arrangement is tighter packing and more layout flexibility. The skilled artisan will appreciate that the number of leads and spokes for a given cluster may be varied. In addition, a cluster arrangement may be used with other types of UBM structures disclosed herein.

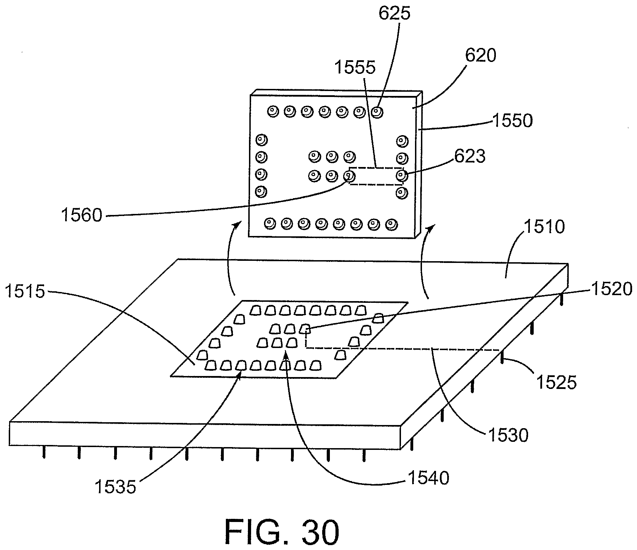

FIG. 30 is a pictorial view of the semiconductor chip 620 peeled upwardly from a printed circuit board 1510 that may be a semiconductor chip package substrate or other type of printed circuit board. When assembled, the semiconductor chip 620 is flip-chip mounted on a bump array 1515 of the package substrate 1510. The bump array 1515 includes a plurality of upwardly facing solder bumps, one of which is labeled 1520, that are designed to engage the solder bumps 623, 625, etc. of the semiconductor chip 620. The substrate 1510 includes some type of interconnect structure to establish input/output with some other electronic device to which the substrate 1510 is connected. In this illustrative embodiment, a pin grid array consisting of a plurality of pins, one of which is labeled 1525, project from the substrate 1510. However, a ball grid array, a land grid array or other type of interconnect may be used. An electrical pathway is established between a given pin, such as the pin 1525, and a given bump location such as the bump location 1520 on the substrate 1510 by way of a electrical interconnect structure which is represented schematically by the dashed line 1530. The interconnect structure 1530 may consist of one or more conductor lines that may or may not be on one or more different levels of interconnect within the substrate 1510.

For various reasons the bump locations positioned around the periphery 1535 of the bump array 1515 tend to be dedicated to the input/output of signals and the core pad locations 1540 of the array 1515 tend to be dedicated to the input/output of power and ground. This traditional design approach works satisfactorily for many design situations. However, there are certain design situations in which a so-called deep bump, that is, a bump, such as the bump 623 on the semiconductor chip 620 that is located relatively close to an edge 1550 of the chip 620, requires a power or ground input/output. Since the peripheral bump locations 1535 of the array 1515 tend to be dedicated to signal input/output, it may be necessary to fashion some sort of buried interconnect arrangement in the substrate 1510 in order to route power or ground from a given pin 1525 to a peripherally located pad site on the array 1515. This solution can present both a cost penalty and perhaps performance issues if the substrate trace routing has to be modified significantly. However, the use of UBM routing as disclosed herein may be used to route power or ground input/output to such a deep bump 623. In this regard, a UBM routing structure 1555 is electrically connected to the deep bump 623 and one of the centrally located bumps 1560 of the chip 620. The UBM structure 1555 is shown in phantom since there will be insulating material disposed between the bumps 623 and 1560 and the underlying UBM structure 1555. The UBM 1555 structure may be configured as described in any of the embodiments disclosed herein.

Any of the exemplary embodiments disclosed herein may be embodied in instructions disposed in a computer readable medium, such as, for example, semiconductor, magnetic disk optical disk or other storage medium or as a computer data signal. The instructions or software may be capable of synthesizing and/or simulating the circuit structures disclosed herein. For example, an electronic design automation program, such as Cadence APD or the like, may be used to synthesize the disclosed circuit structures. The resulting code may be used to fabricate the disclosed circuit structures. In another example, a simulation program, such as a high frequency SPICE simulator or the like, may be used to simulate the electrical behavior of the disclosed circuit structures.

While the invention may be susceptible to various modifications and alternative forms, specific embodiments have been shown by way of example in the drawings and have been described in detail herein. However, it should be understood that the invention is not intended to be limited to the particular forms disclosed. Rather, the invention is to cover all modifications, equivalents and alternatives falling within the scope of the invention as defined by the following appended claims.

## Claims

1. A method of semiconductor processing, comprising:
forming an underbump metallization structure on a semiconductor chip, the underbump metallization structure having a first site (1270,1300) electrically connected to a first redistribution layer structure (1230) and a second site (1280,1290) electrically connected to a second redistribution layer structures, (1235), said redistribution layer structures providing electrical routing between circuit devices in the semiconductor chip and the underbump metallization structure;
wherein the forming of the underbump metallization structure comprises forming a cluster having a central hub (1305) situated between the first and second redistribution layer structures (1230,1235), whereby the first and second sites are connected to the central hub (1305) by respective first (1315) and second (1325) spokes; and
forming a solder structure (1350) on the central hub.

2. The method of claim 1, comprising not forming a solder structure on a hub of an additional cluster of the underbump metallization structure.

3. The method of claim 1, wherein the forming the underbump metallization structure comprises forming a conductor grid having a first site electrically coupled to a third redistribution layer structure and a second site electrically coupled to a fourth redistribution layer structure.

4. The method of claim 1, comprising coupling the semiconductor chip to a substrate and mounting the substrate in a computing device.

5. A semiconductor chip, comprising:
at least two redistribution layer structures (1230,1235);
an underbump metallization structure on the semiconductor chip, the underbump metallization structure having a first site (1270,1300) electrically connected to a first (1230) of the at least two redistribution layer structures and a second site (1280,1290) electrically connected to a second (1235) of the at least two redistribution layer structures, said redistribution layer structures providing electrical routing between circuit devices in the semiconductor chip and the underbump metallization structure;
wherein the underbump metallization structure comprises a cluster having a central hub (1305) situated between the first and second redistribution layer structures (1230,1235) and the first and second sites (1270,1300,1280,1290) coupled to the central hub (1305) by respective first (1315) and second (1325) spokes; and
a solder structure (1350) on the central hub.

6. The apparatus of claim 5 wherein the at least two redistribution layer structures comprise part of the same type of electrical pathway, wherein the electrical pathway is one of ground, power or signal.

7. The apparatus of claim 5 wherein underbump metallization structure comprises a conductor grid having a first site coupled to a first of at least two additional redistribution layer structures and a second site coupled to a second of the at least two redistribution layer structures (1245 etc).

8. The apparatus of claim 5, wherein there is not a solder structure on a hub of an additional cluster of the underbump metallization structure.

9. The apparatus of claim 5, comprising a substrate coupled to the semiconductor chip.

10. The apparatus of claim 9, comprising a computing device coupled to the substrate.

## Patentansprüche

1. Verfahren zur Halbleiterverarbeitung, das Folgendes umfasst:
das Formen einer Under-Bump-Metallisierungsstruktur auf einem Halbleiterchip, wobei die Under-Bump-Metallisierungsstruktur einen ersten Platz (1270, 1300), der elektrisch mit einer ersten Umverdrahtungsebenenstruktur (1230) verbunden ist, und einen zweiten Platz (1280, 1290), der elektrisch mit einer zweiten Umverdrahtungsebenenstruktur (1235) verbunden ist, hat, wobei die Umverdrahtungsebenenstrukturen eine elektrische Leitungsführung zwischen Schaltkreis-Vorrichtungen in dem Halbleiterchip und der Under-Bump-Metallisierungsstruktur bereitstellen,
wobei das Formen der Under-Bump-Metallisierungsstruktur das Formen eines Bündels umfasst, das einen zentralen Knotenpunkt (1305) hat, der zwischen der ersten und der zweiten Umverdrahtungsebenenstruktur (1230, 1235) angeordnet ist, wodurch der erste und der zweite Platz durch jeweilige erste (1315) und zweite (1325) Speichen mit dem zentralen Knotenpunkt (1305) verbunden sind,
das Formen einer Lötstruktur (1350) auf dem zentralen Knotenpunkt.

2. Verfahren nach Anspruch 1, das umfasst, keine Lötstruktur auf einem Knotenpunkt eines zusätzlichen Bündels der Under-Bump-Metallisierungsstruktur zu formen.

3. Verfahren nach Anspruch 1, wobei das Formen der Under-Bump-Metallisierungsstruktur das Formen eines Leitergitters umfasst, das einen ersten Platz, der elektrisch mit einer dritten Umverdrahtungsebenenstruktur verbunden ist, und einen zweiten Platz, der elektrisch mit einer vierten Umverdrahtungsebenenstruktur verbunden ist, hat.

4. Verfahren nach Anspruch 1, welches das Koppeln des Halbleiterchips an ein Substrat und das Montieren des Substrats in einer Datenverarbeitungsvorrichtung umfasst.

5. Halbleiterchip, der Folgendes umfasst:
wenigstens zwei Umverdrahtungsebenenstrukturen (1230, 1235),
eine Under-Bump-Metallisierungsstruktur auf dem Halbleiterchip, wobei die Under-Bump-Metallisierungsstruktur einen ersten Platz (1270, 1300), der elektrisch mit einer ersten (1230) der wenigstens zwei Umverdrahtungsebenenstrukturen verbunden ist, und einen zweiten Platz (1280, 1290), der elektrisch mit einer zweiten (1235) der wenigstens zwei Umverdrahtungsebenenstrukturen verbunden ist, hat, wobei die Umverdrahtungsebenenstrukturen eine elektrische Leitungsführung zwischen Schaltkreis-Vorrichtungen in dem Halbleiterchip und der Under-Bump-Metallisierungsstruktur bereitstellen,
wobei die Under-Bump-Metallisierungsstruktur ein Bündel umfasst, das einen zentralen Knotenpunkt (1305) hat, der zwischen der ersten und der zweiten Umverdrahtungsebenenstruktur (1230, 1235) angeordnet ist, wodurch der erste und der zweite Platz (1270, 1300, 1280, 1290) durch jeweilige erste (1315) und zweite (1325) Speichen an den zentralen Knotenpunkt (1305) gekoppelt sind,
eine Lötstruktur (1350) auf dem zentralen Knotenpunkt.

6. Vorrichtung nach Anspruch 5, wobei die wenigstens zwei Umverdrahtungsebenenstrukturen einen Teil der gleichen Art von elektrischer Leitungsbahn umfassen, wobei die elektrische Leitungsbahn eines von Erde, Leistung oder Signal ist.

7. Vorrichtung nach Anspruch 5, wobei die Under-Bump-Metallisierungsstruktur ein Leitergitter umfasst, das einen ersten Platz, der an eine erste von wenigstens zwei zusätzlichen Umverdrahtungsebenenstrukturen gekoppelt ist, und einen zweiten Platz, der an eine zweite der wenigstens zwei zusätzlichen Umverdrahtungsebenenstrukturen (1245 usw.) gekoppelt ist, hat.

8. Vorrichtung nach Anspruch 5, wobei es keine Lötstruktur auf einem Knotenpunkt eines zusätzlichen Bündels der Under-Bump-Metallisierungsstruktur gibt.

9. Vorrichtung nach Anspruch 5, die ein an den Halbleiterchip gekoppeltes Substrat umfasst.

10. Vorrichtung nach Anspruch 9, die eine an das Substrat gekoppelte Datenverarbeitungsvorrichtung umfasst.

## Revendications

1. Procédé de traitement de semi-conducteur, comprenant les étapes consistant à :
former une structure de métallisation sous bossage sur une puce à semi-conducteur, la structure de métallisation sous bossage présentant un premier site (1270, 1300) électriquement raccordé à une première structure à couche de redistribution (1230) et un deuxième site (1280, 1290) électriquement raccordé à une deuxième structure à couche de redistribution (1235), lesdites structures à couche de redistribution fournissant un routage électrique entre des dispositifs formant circuit situés dans la puce à semi-conducteur et la structure de métallisation sous bossage ;
dans lequel l'étape de formation de la structure de métallisation sous bossage comprend une étape consistant à former un groupe présentant un concentrateur central (1305) situé entre les première et deuxième structures à couche de redistribution (1230, 1235), grâce à quoi les premier et deuxième sites sont raccordés au concentrateur central (1305) grâce à des premier (1315) et deuxième (1325) rayons respectifs ; et
former une structure de soudure (1350) sur le concentrateur central.

2. Procédé selon la revendication 1, comprenant une étape consistant à ne pas former une structure de soudure sur un concentrateur d'un groupe supplémentaire de la structure de métallisation sous bossage.

3. Procédé selon la revendication 1, dans lequel l'étape de formation de la structure de métallisation sous bossage comprend une étape consistant à former une grille conductrice présentant un premier site électriquement couplé à une troisième structure à couche de redistribution et un deuxième site électriquement couplé à une quatrième structure à couche de redistribution.

4. Procédé selon la revendication 1, comprenant une étape consistant à coupler la puce à semi-conducteur à un substrat et à monter ledit substrat dans un dispositif informatique.

5. Puce à semi-conducteur, comprenant :
au moins deux structures à couche de redistribution (1230, 1235) ;
une structure de métallisation sous bossage sur la puce à semi-conducteur, la structure de métallisation sous bossage présentant un premier site (1270, 1300) électriquement raccordé à une première (1230) parmi les au moins deux structures à couche de redistribution et un deuxième site (1280, 1290) électriquement raccordé à une deuxième (1235) parmi les au moins deux structures à couche de redistribution, lesdites structures à couche de redistribution fournissant un routage électrique entre les dispositifs formant circuit situés dans la puce à semi-conducteur et la structure de métallisation sous bossage ;
dans laquelle la structure de métallisation sous bossage comprend un groupe présentant un point nodal central (1305) situé entre les première et deuxième structures à couche de redistribution (1230, 1235) et les premier et deuxième sites (1270, 1300, 1280, 1290) couplés au point nodal central (1305) grâce à des premier (1315) et deuxième (1325) rayons respectifs ; et
une structure de soudure (1350) sur le point nodal central.

6. Appareil selon la revendication 5, dans lequel les au moins deux structures à couche de redistribution comprennent une partie du même type de chemin électrique, dans lequel le chemin électrique est un parmi la terre, une alimentation électrique ou un signal.

7. Appareil selon la revendication 5, dans lequel la structure de métallisation sous bossage comprend une grille conductrice présentant un premier site couplé à une première parmi au moins deux structures à couche de redistribution supplémentaires et un deuxième site couplé à une deuxième parmi les au moins deux structures à couche de redistribution (1245, etc.).

8. Appareil selon la revendication 5, dans lequel il n'y a pas de structure de soudure sur un concentrateur d'un groupe supplémentaire de la structure de métallisation sous bossage.

9. Appareil selon la revendication 5, comprenant un substrat couplé à la puce à semi-conducteur.

10. Appareil selon la revendication 9, comprenant un dispositif informatique couplé au substrat.
